# EUROPÄISCHE PATENTSCHRIFT

(11) **EP 0 618 763 B1**
(45) Veröffentlichungstag und Bekanntmachung des Hinweises auf die Patenterteilung: **11.10.1995**
(21) Anmeldenummer: 94104244.2
(22) Anmeldetag: 17.03.1994
(51) Int. Cl.: H05K 9/00

(54) **Abgeschirmtes Gehäuse zur Aufnahme von elektrisch betriebenen Elementen mit einer Steckerinsel für interne und externe Anschlusskabel**
Shielded casing for electric elements with plug for internal and external cable connection
Boîte blindée pour des éléments électriques avec une fiche pour un câble interne et externe

(30) Priorität: 30.03.1993 DE 9304825 U
(43) Veröffentlichungstag der Anmeldung: 05.10.1994
(73) Patentinhaber: SIEMENS AKTIENGESELLSCHAFT, 80333 München (DE)
(72) Erfinder: Schneeberger, Reinhold, Dipl.-Ing. (FH), D-90556 Seukendorf (DE)

(56) Entgegenhaltungen:
- EP-A- 0 424 606
- DE-U- 9 211 291
- GB-A- 2 270 206

## Beschreibung

Die Erfindung betrifft ein Gehäuse zur Aufnahme von elektrisch betriebenen Elementen, insbesondere von Leiterplatten.

Aus EP-A-0 424 606 ist ein Gehäuse für zwei miteinander nicht verträgliche Schaltungen bekannt. Dieses Gehäuse weist zwei Kammern auf, die durch zwei elektrisch leitende Wände getrennt sind.

In der elektrischen Aufbautechnik müssen bei der Gestaltung von Gehäusen, welche das Anstecken von externen elektrischen Anschlußleitungen ermöglichen, in Bezug auf deren Abschirmeigenschaften und deren Handhabbarkeit eine Vielzahl von Randbedingungen beachtet werden. Das Problem besteht dabei darin, daß diese Randbedingungen zum Teil gegensätzlich sind. So müssen die Gehäuse in aller Regel sowohl gegen äußere Umwelteinflüsse, wie z.B. Feuchtigkeit und Staub, als auch gegen die Einwirkung von äußeren bzw. die Abstrahlung von inneren elektromagnetischen Störfeldern abgeschirmt sein. Die hierzu erforderlichen Maßnahmen bedingen einen allseitig "dichten", geschlossenen Aufbau eines Gehäuses.

Hierdurch wird aber zwangsläufig die Zugänglichkeit von dessen Innenraum behindert. Weiterführende externe Anschlußkabel zur Energieversorgung und Datenübertragung können in der Regel nur dann angebracht werden, wenn das Gehäuse gegebenenfalls mit erheblichem Aufwand geöffnet wurde. Beim Wiederzusammenbau muß dann sichergestellt werden, daß alle Dichtungsmittel wieder ordungsgemäß in Funktion kommen. Nach Wiederverschluß des Gehäuses muß z.B. die elektromagnetische Abschirmung der innenliegenden, elektrisch betriebenen Elemente gegen die Einstrahlung und die Abstrahlung von elektromagnetischen Störfeldern wiederhergestellt sein. Ferner müssen weitere, insbesondere gegen äußere Umwelteinflüsse wie z.B. Feuchtigkeit und Staub wirkende Dichtungsmittel wieder funktionieren.

Ein weiteres Problem besteht darin, daß der zum Anstecken weiterführender externer Anschlußkabel benötigte Raum das Gesamtvolumen des Gehäuses häufig stark vergrößert. Insbesondere bei Kabeln, welche zur Datenübertragung dienen, sind vielpolige Anschlußstecker mit großen Abmessungen notwendig. Zudem muß der von den Anschlußsteckern eingenommene Steckbereich in der gleichen Weise wie das Gehäuse selbst gegen elektromagnetische Strahlung und Umwelteinflüsse abgeschirmt werden, was dann die oben dargestellt Gestaltungsprobleme verursacht.

Der Erfindung liegt die Aufgabe zugrunde, ein zur Aufnahme von elektrisch betriebenen Elementen dienendes Gehäuse derart auszugestalten, daß externe Anschlußkabel zur Energieversorgung und zum Datenaustausch in einer leicht zugänglichen, platzsparenden und abgeschirmten Weise am Gehäuse kontaktiert werden können, und daß hierdurch die Abschirmeigenschaften des Gehäuses und des von den Steckern der Anschlußkabel eingenommenen Raumes gegenüber elektrischen und umweltbedingten Einflüssen möglichst wenig beeinträchtigt werden.

Die Aufgabe wird gelöst mit dem in Anspruch 1 angegebenen Gehäuse. Vorteilhafte weitere Ausführungformen des Gehäuses sind in den Unteransprüchen enthalten.

Das erfindungsgemäße Gehäuse weist ein in elektrisch abschirmender Ausführung aufgebautes Gehäusehauptteil auf. Dieses dient zur Aufnahme von elektrisch betriebenen Elementen, z.B. von Baugruppen. An wenigstens einer Seite des Teiles ist eine Durchführungsöffnung vorhanden, durch die interne Anschlußkabel zur Versorgung der elektrisch betriebenen Elemente herausgeführt werden können. Diese Durchführungsöffnung ist erfindungsgemäß durch eine muldenförmige Steckerinsel elektrisch abgeschirmt verschließbar.

Die Mulde der Steckerinsel erstreckt sich dabei bevorzugt außerhalb des üblichen Innenraumes des Gehäusehauptteiles. Im geschlossenen Zustand des Gehäuses bildet die außenliegende Steckerinsel quasi eine höcker-, nasen- bzw. pilzförmige Ausbuchtung. Bei entsprechender Größe des Bodens der Steckerinsel kann die Mulde auch in das Gehäusehauptteil hineinragen. Die Steckerinsel bildet dann quasi eine wannenförmige Vertiefung.

Erfindungsgemäß ist in der außenliegenden, umlaufenden Seitenwand der muldenförmigen Steckerinsel mindestens ein Übergabestecker eingelassen. An dessen Innenseite ist ein von den elektrisch betriebenen Elementen im Gehäuseinneren herangeführtes internes Anschlußkabel anschließbar. An dessen Außenseite ist ein weiterführendes, externes Anschlußkabel anschließbar. Diese Gestaltung hat den besonderen Vorteil, daß die Übergabestecker an den Enden von externen Anschlußkabeln in einer liegenden Position relativ zur Fläche des Gehäusehaupteiles an die Übergabestecker in der umlaufenden Seitenwand der muldenförmigen Steckerinsel anschließbar sind. Die Steckerinsel bildet somit quasi eine abgeschirmte, pilz- oder wannenförmige Übergabestelle für elektrische Energie und elektrische Steuersignale, in deren umlaufenden Seitenwand eine Vielzahl von Übergabesteckern eingelassen sein können, an die wiederum die Stecker an den Enden externer Anschlußkabel in liegender Position und konzentrischer Anordnung ansteckbar sind.

Aufgrund der erfindungsgemäßen Ausführung der muldenförmigen Steckerinsel wird sowohl eine doppelstöckige als auch eine gegenüber der umgebenden Seitefläche des Gehäusehauptteiles senkrecht abstehende Position von Steckern an externen Anschlußkabeln vermieden. Die Tiefe einer derart gebildeten Steckerinsel kann annähernd auf die Breite von Steckern an externen Anschlußkabeln begrenzt werden. Sie ist damit erheblich niedriger, als wenn die Stecker in stehender Anordnung auf einer Seite des Gehäusehauptteiles aufgesteckt wären. Die erfindungsgemäße, muldenförmige Steckerinseln bilden somit eine besonders flache, elektrisch abgeschirmte Übergabestelle für elektrische Energie und elektrische Steuersignale.

Bei einer weiteren Ausführungsform weist das erfindungsgemäße Gehäuse zusätzlich eine abnehmbare Abdeckwanne auf. Die Abdeckwanne verfügt über mindestens eine abgedichtete Durchführung mindestens ein externes Anschlußkabel und bevorzugt über eine umlaufende Dichtnut. Die Wanne ist mit dem Gehäusehauptteil derart verbindbar, daß die Steckerinsel vollständig umschlossen und somit gegen Unwelteinflüsse wie insbesondere Feuchtigkeit und Staub abgedichtet ist. Aufgrund der vorteilhaften Gestaltung der muldenförmigen Steckerinsel muß auch die abnehmbare Abdeckwanne nur eine geringe Bautiefe aufweisen.

Die Erfindung macht sich somit zunutze, daß die meisten, zur Aufnahme von elektrisch betriebenen Elementen dienenden Gehäuse zumindest über eine großflächige Außenseite verfügen. In dieser Außenseite kann die Durchführungsöffnung für interne Anschlußkabel vorteilhaft vorgesehen werden, welche dann durch die muldenförmige Steckerinsel elektrisch abgeschirmt verschließbar ist. Um die Steckerinsel können ohne nennenswerten Höhenaufwand auch vielpolige Übergabestecker von externen Anschlußkabeln liegend positioniert werden. Durch die Erfindung werden somit an den schmalen Stirn bzw. Hinterseiten von Gehäusen angeordnete tiefe Schächte zur Aufnahme von senkrecht stehenden und parallel reihenartig angeordneten Übergabesteckern von externen Anschlußkabeln vermieden.

Die Erfindung wird unter Zuhilfenahme von zwei, in den nachfolgend kurz angeführten Figuren dargestellten Ausführungsbeispielen näher erläutert. Dabei zeigt
- FIG 1: das Beispiel eines gemäß der Erfindung gestalteten zweiteiligen Gehäuses in Standausführung, und
- FIG 2: das Beispiel eines gemäß der Erfindung gestalteten Fronteinbaugehäuses.

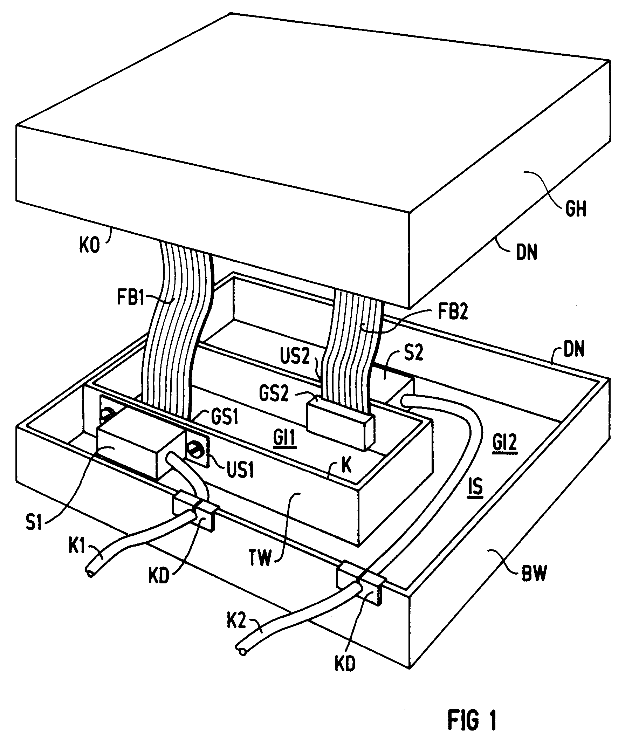

Im Beispiel der Figur 1 dient ein abgeschirmt ausgeführtes Gehäusehauptteil GH zur Aufnahme von elektrisch betriebenen Elementen. Auf der nicht sichtbaren Unterseite ist eine Durchführungsöffnung KO für interne Anschlußkabel zur Versorgung der elektrisch betriebenen Elemente vorhanden. In in Figur 1 sind beispielhaft zwei derartige, interne Anschlußkabel FB1,FB2 in Form von nicht abgeschirmten Flachband-Buskabeln herausgeführt, welche jeweils mit einem Übergabestecker GS1,GS2 abgeschlossen sind.

Erfindungsgemäß ist eine muldenförmige Steckerinsel in abschirmender Ausführung vorhanden, welche zumindest aus einer bevorzugt streifenförmigen, ringförmig geschlossenen Seitenwand TW besteht. Die umlaufende Seitenwand kann nach unten durch einen separaten, ebenfalls elektrisch abschirmenden Boden B abgeschlossen sein. Die sichtbare Oberkante der umlaufenden Seitenwand TW ist im Beispiel der Figur 1 als eine sogenannte EMV-Kontaktkante K ausgeführt. Hierüber wird dann, wenn die muldenförmige Steckerinsel die Durchführungsöffnung KO auf der Unterseite des Gehäusehauptteiles GH abdeckt, eine leitende und somit elektromagnetisch dichte Kontaktierung zwischen der muldenförmigen Steckerinsel und dem Gehäusehauptteil GH hergestellt.

Im Beispiel der Figur 1 sind erfindungsgemäß zwei Übergabestecker US1,US2 in die umlaufende Seitenwand TW der Steckerinsel eingelassen. An deren Innenseiten sind die internen Anschlußkabel FB1,FB2 über deren Stecker GS1,GS2 anschließbar. An deren Außenseite ist je ein weiterführendes, externes Anschlußkabel K1,K2 über je einen Abschlußstecker S1,S2 angeschlossen. Man erkennt, daß aufgrund der erfindungsgemäßen muldenförmigen Gestaltung der Steckerinsel die recht tiefen Stecker S1,S2 an den Enden der Kabel K1,K2 eine platzsparende, liegende Position relativ zur dahinterliegenden Hauptfläche des Gehäusehauptteiles GH einnehmen.

Aus Gründen der besseren Übersicht sind in Figur 1 lediglich zwei Übergabestecker US1,US2 gegenüberliegenden in Seitenwände TW der Steckerinsel eingelassen. Selbstverständlich können mehrere Übergabestecker und auf alle Seitenwände verteilt angebracht sein. Bevorzugt sind die Seitenwände in rechteckiger bzw. quadratischer Form ringförmig geschlossen. Sie können aber auch zur Gestalt eines Rechteckes bzw. Vieleckes geformt sein, wobei dann bevorzugt in jeder ebenen Seitenfläche des Vieleckes ein Übergabestecker eingelassen ist.

Im Beispiel der Figur 1 ist zusätzlich eine abnehmbare Abdeckwanne BW vorhanden. Diese hat bevorzugt die gleichen äußeren Abmessungen wie das Gehäusehauptteil GH und kann mit diesem über eine umlaufende Dichtnut DN feuchtigkeits- und staubdicht verschlossen werden. Externe Anschlußkabel K1,K2 in Form von bevorzugt abgeschirmten und feuchtigkeitsgeschützten Rundkabeln sind über feuchtigkeitsdichte Kabeldurchführungen KD durch die Seiten der Abdeckwanne BW hindurchgeführt. Bei der in Figur 1 dargestellten Ausführung der Erfindung kann die Steckerinsel bei Öffnung des Gehäuses gemeinsam mit der Abdeckwanne BW vom Gehäusehauptteil GH getrennt werden. Im geöffneten Zustand kommt die muldenförmige Steckerinsel somit auf der Innenseite IS der Abdeckwanne BW zuliegen. Diese dient dann quasi als ein Träger. Es ist nun auf einfache und bequeme Weise möglich, die internen und externen Anschlußkabel betreffende Montage und Reparaturarbeiten an der in der Abdeckwanne BW liegenden Steckerinsel vorzunehmen.

Ist bei dem in Figur 1 dargestellten Beispiel die Abdeckwanne BW aus einem nichtleitenden Material hergestellt, z.B. aus Kunststoff, so besteht die Seitenwand TW der Steckerinsel aus einem elektrisch leitenden Material, z.B. einem ringförmig gebogenen und an der Stoßkante verlöteten Blechstreifen. Dieser ist über ein zusätzliches, auf der Innenseite IS der Abdeckwanne BW aufliegendes Bodenblech B elektromagnetisch dicht verschlossen.

Ist andererseits die Abdeckwanne BW selbst aus einem elektrisch leitenden und somit elektromagnetisch abschirmenden Material gefertigt, so kann eine separate Bodenplatte B unterhalb der umlaufenden Seitenwand TW der Steckerinsel entfallen. Die Seitenwand TW ist in diesem Fall direkt auf der Innenseite IS der Abdeckwanne bevorzugt aufgelötet bzw. aufgeschweißt. Bei dem in Figur 1 dargestellten Beispiel fällt zusätzlich die linke Seite der Steckerinsel mit der linken Außenwand der Abdeckwanne BW zusammen.

Bei Vorhandensein einer zusätzlichen Abdeckwanne wird über den davon umschlossenen Raum und die darin befindliche muldenförmige Steckerinsel vorteilhaft eine räumliche Trennung von elektromagnetischer Abschirmung und der Abdichtung gegenüber Umwelteinflüssen, z.B. Feuchtigkeit, bewirkt.

So ist im Beispiel der Figur 1 der erste Innenraum GI1, welcher von der umlaufenden Seitenwand TW und dem gegebenenfalls separat vorhandenen Boden B der Steckerinsel begrenzt wird, und der sich über die in Figur 1 nicht sichtbare Kabeldurchführungsöffnung KO in das Innere des Gehäusehauptteiles GH fortsetzt, elektromagnetisch abgeschirmt. Zur Verbesserung dieser Abschirmwirkung ist es weiterhin vorteilhaft, wenn die in die Seitenwand TW der Steckerinsel eingelassenen Übergabestecker US1,US2 zusätzliche EMV-Ableitungen aufweisen. Hierduch werden Kabelabschirmungen der externen Anschlußkabel K1,K2 mit der elektrisch leitenden Steckerinsel und im geschlossenen Zustand mit dem restlichen Gehäusehauptteil GH kontaktiert.

Ferner ist in Figur 1 der die Steckerinsel umgebende Innenraum GI2 innerhalb der umgebenden Abdeckwanne BW feuchtigkeitsgeschützt. Das erfindungsgemäße Gehäuse weist somit eine "zweischalige" Abschirmung auf. Dabei übernimmt die äußere, insbesondere aus der Abdeckwanne BW bestehende Schale den Schutz gegenüber Umwelteinflüssen, wie z.B. Feuchtigkeit und Staub. Die innenliegende, im wesentlichen aus der muldenförmigen Steckerinsel und der umgebenden Fläche des Gehäusehauptteiles bestehenden Schale übernimmt schließlich den Schutz gegenüber der Ein- bzw. Abstrahlung von elektromagnetischen Störfeldern.

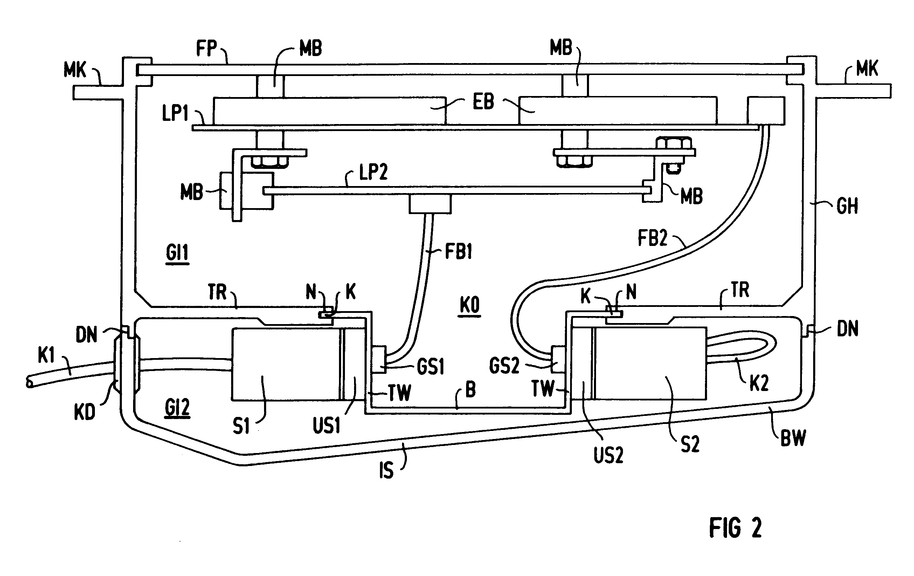

In Figur 2 ist ein zweites Beispiel für ein gemäß der Erfindung gestaltetes Gehäuse dargestellt. Es handelt sich dabei um ein "Fronteinbaugehäuse". Hierzu sind an der Außenseite des Gehäusehauptteiles GH streifenförmige Montagekanten MK vorgesehen, über welche das Gehäuse z.B. in Rahmenkonstruktionen einschraubbar ist. In eine Frontplatte an der Vorderseite FP können z.B. von außen zugängliche Anzeige- und Bedienelemente eingelassen werden .

In Figur 2 sind im Inneren des Gehäusehauptteiles GH beispielhaft zwei Baugruppen LP1,LP2 als elektrisch betriebene Elemente dargestellt. Diese sind über Montagebolzen und Winkelelemente MB beispielhaft an der Frontplatte FB montiert. Zur elektrischen Energieversorgung und zum Datenaustausch dienen Flachband-Buskabel FB1,FB2, welche jeweils von einer Leiterplatte LP2,LP1 abgehen. Diese internen Anschlußkabel sind durch eine Durchgangsöffnung KO hindurchgeführt, welche sich in einer großflächigen Seitenwand TR des Gehäusehauptteiles GH befindet.

Erfindungsgemäß ist die Durchführungsöffnung KO mit einer muldenförmigen und im Beispiel der Figur 2 nach außen gewölbten Steckerinsel elektrisch abschirmend verschlossen. Die ringförmig geschlossenen, umlaufenden Seitenwände TW der Steckerinsel sind über ein Bodenteil B verschlossen und über abgewinkelte EMV-Kontaktkanten K mechanisch fest und elektromagnetisch dicht in Nuten N eingelassen, welche sich in der großflächigen Seitenwand TR um die Durchführungsöffnung KO herum befinden. Die muldenförmige Steckerinsel und das Gehäusehauptteil GH bilden somit eine abgeschirmte Baueinheit, in dessen Innenraum GI1 die elektrisch betriebenen Elemente in Form der beispielhaften Baugruppen LP1,LP2 angeordnet sind.

Erfindungsgemäß sind auch hier in den Seitenwänden TW der Steckerinsel Übergabestecker US1,US2 bevorzugt mit zusätzlicher EMV-Ableitung eingelassen. An deren Innenseite sind die herangeführten internen Anschlußkabel FB1,FB2 über deren Abschlußstecker GS1, GS2 angeschlossen. An deren Außenseite sind wiederum weiterführende, externe Anschlußkabel K1,K2 über vielpolige Abschlußstecker S1,S2 in vorteilhaft platzsparender liegender Position anschließbar.

Diese außerhalb der Seitenwand TR des Gehäusehauptteiles GH um die muldenförmige Steckerinsel TW,BK befindliche "Steckeranchlußebene" kann wiederum über eine abnehmbare Abdeckwanne zusätzlich gegen Umwelteinflüsse geschützt werden. Hierzu ist im Beispiel der Figur 2 eine Abdeckwanne BW über eine Dichtnut DN mit dem Gehäusehauptteil derart verbindbar, daß die Steckerinsel innenliegend vollständig dicht umschlossen wird. Die externen Anschlußkabel K1,K2 werden wiederum über abgedichtete Durchführungen KD durch die Wand der Abdeckwanne BW nach außen geführt. Bei einer anderen, nicht dargestellten Ausführung können die Seiten der Abdeckwanne auch Bestandteil des Gehäusehauptteiles sein, so daß in diesem Fall die Abdeckwanne die Form eines Abdeckbleches annimmt. Bei einer weiter, nicht dargestellten Ausführung können sowohl Seitenwände TW als auch Boden B Bestandteil des Gehäusehauptteiles sein. In diesen Fällen muß Seitenwand TR des Gehäusehauptteiles aber über eine ausreichende Fläche verfügen, damit eine Montage von Steckern S1,S2 in liegender Position um die muldenförmige Steckerinsel herum möglich ist.

An der Schnittbilddarstellung von Figur 2 sind die mit der erfindungsgemäßen Gestaltung erzielbaren Vorteile besonders deutlich zu erkennen. So wird aufgrund der beispielhaft nach außen gerichteten Steckerinsel und der somit liegenden Anordnung der in die Übergabestecker US1,US2 eingesteckten Abschlußstecker S1,S2 externer Kabel K1,K2 ein sehr niedriger Steckerbereich auf der Rückseite des Gehäusehauptteiles GH erzeugt. Dessen Höhe und somit die Höhe einer möglicherweise zusätzlich vorhandenen Abdeckwanne BW können klein gehalten werden, während zur Unterbringung der Abschlußstecker S1,S2 die Fläche der Seitenwand TR um die Durchführungsöffnung KO ausgenutzt wird.

## Patentansprüche

1. Gehäuse zur Aufnahme von elektrisch betriebenen Elementen, insbesondere von Leiterplatten (LP1,LP2), mit
a) einem Gehäusehauptteil (GH) in zumindest elektrisch abschirmender Ausführung zur Aufnahme der elektrisch betriebenen Elemente, welches mindestens eine Durchführungsöffnung (KO) für ein internes Anschlußkabel (FB1,GS1;FB2,GS2) zur Versorgung der elektrisch betriebenen Elemente aufweist, und mit
b) einer muldenförmigen Steckerinsel (TW,B,K,US1,US2) in elektrisch abschirmender Ausführung,
b1) die so geformt ist, daß die Durchführungsöffnung (KO) elektrisch abgeschirmt verschließbar ist, und
b2) in deren umlaufender Seitenwand (TW) mindestens ein Übergabestecker (US1,US2) eingelassen ist, wobei an dessen Innenseite das interne Anschlußkabel (FB1, GS1;FB2,GS2) und an dessen Außenseite ein externes Anschlußkabel (K1;K2) mit einem Anschlußstecker (S1;S2) in liegender Position anschließbar ist.

2. Gehäuse nach Anspruch 1 mit einer abnehmbaren Abdeckwanne (BW), welche eine abgedichtete Durchführung (KD) für das mindestens eine externe Anschlußkabel (K1;K2) aufweist, und welche unter vollständigem Abschluß der Steckerinsel (TW,B,K,US1,US2) gegen Umwelteinflüsse mit dem Gehäusehauptteil (GH) verbindbar ist (DN).

3. Gehäuse nach Anspruch 1 oder 2, wobei der mindestens eine Übergabestecker (US1,US2) eine am Körper der muldenförmigen Steckerinsel (TW,B,K,US1,US2) angeschlossene EMV-Ableitung für die Abschirmung eines externen Anschlußkabels (K1,S1;K2,S2) aufweist.

## Claims

1. Housing for receiving electrically driven elements, in particular printed-circuit boards (LP1, LP2), having
a) a housing main part (GH), designed at least for electrical shielding, for receiving the electrically driven elements, which housing main part has at least one lead-out aperture (CI) for an internal connecting cable (FB1, GS1; FB2, GS2) for supplying the electrically driven elements, and having
b) a trough-shaped plug island (TW, B, K, US1, US2), designed for electrical shielding,
b1) which is formed so that the lead-out aperture (CI) can be closed off in an electrically shielded manner, and
b2) which has at least one adaptor connector (US1, US2) embedded in the circumferential side wall (TW), wherein the internal connecting cable (FB1, GS1; FB2, GS2) can be connected to the inner side of the said adaptor connector, and an external connecting cable (K1; K2) having a cable connector (S1; S2) can be connected in a horizontal position to the outer side of the said adaptor connector.

2. Housing according to claim 1, having a removable, tub-shaped covering body BW, which has a sealed bushing (KD) for an external connecting cable (K1; K2), there being at least one of these connecting cables, and which can be connected (DN) to the housing main part (GH) with total closure of the plug island (TW, B, K, US1, US2) against environmental influences.

3. Housing according to claim 1 or 2, wherein the adaptor connector (US1, US2), of which there is at least one, has an EMV terminal lead connected to the body of the trough-shaped plug island (TW, B, K, US1, US2) for shielding an external connecting cable (K1, S1; K2, S2).

## Revendications

1. Boîtier pour loger des éléments à fonctionnement électrique, notamment des plaquettes à circuits imprimés (LP1, LP2), comportant
a) une partie de boîtier principale (GH), constituée au moins selon une forme de réalisation blindée du point de vue électrique, sert à loger les éléments à fonctionnement électrique, et qui possède au moins une ouverture de passage (KO) pour un câble interne de raccordement (FB1,GS1;FB2,GS2) pour l'alimentation des éléments à fonctionnement électrique, et
b) un bloc de connecteur en forme d'auge (TW,B,K,US1,US2) réalisé sous une forme blindée du point de vue électrique,
b1) qui est conçue de telle sorte que l'ouverture de passage (KO) puisse être fermée en étant blindée électriquement, et
b2) dans la paroi latérale périphérique (TW) duquel est enchâssé au moins un connecteur de transfert (US1, US2), le câble intérieur de raccordement (FB1,GS1; FB2,GS2) pouvant être raccordé, sur le côté intérieur de ce connecteur, et un câble extérieur de raccordement (K1;K2) pouvant être raccordé, sur le côté extérieur du connecteur, à un connecteur de raccordement (S1;S2) disposé horizontalement.

2. Boîtier suivant la revendication 1 comportant un capot de fermeture amovible en forme de cuvette (BW), qui possède une traversée étanchéifiée (K2) pour le ou les câbles externes de raccordement (K1;K2), et qui peut être relié (DN) à la partie principale (GH) du boîtier en protégeant complètement le bloc de connecteur (TW,B,K,US1,US2) vis-à-vis d'influences de l'environnement.

3. Boîtier suivant la revendication 1 ou 2, dans lequel le ou les connecteurs de transfert (US1,US2) comportent une dérivation EMV, qui est raccordée au corps du bloc de connecteur en forme d'auges (TW,B,K,US1,US2), pour le blindage d'un câble extérieur de raccordement (K1,S1; K2,S2).
